# EUROPÄISCHE PATENTSCHRIFT

(11) **EP 1 952 437 B1**
(45) Veröffentlichungstag und Bekanntmachung des Hinweises auf die Patenterteilung: **25.03.2009**
(21) Anmeldenummer: 06775191.7
(22) Anmeldetag: 15.09.2006
(51) Int. Cl.: H01L 21/687, H01L 21/677

(54) **TRANSPORTVORRICHTUNG FÜR SCHEIBENFÖRMIGE WERKSTÜCKE**
TRANSPORTING APPARATUS FOR DISC-SHAPED WORKPIECES
DISPOSITIF DE TRANSPORT POUR PIÈCES EN FORME DE DISQUE

(30) Priorität: 17.11.2005 CH 18432005
(43) Veröffentlichungstag der Anmeldung: 06.08.2008
(73) Patentinhaber: OC Oerlikon Balzers AG, 9496 Balzers (LI)
(72) Erfinder: SCHOLTE VAN MAST, Bart, CH-9478 Azmoos (CH); CHRIST, Holger, CH-9478 Azmoos (CH)
(74) Vertreter: Wegmann, Urs
(86) Internationale Anmeldenummer: PCT/CH2006/000498
(87) Internationale Veröffentlichungsnummer: WO 2007/056875

(56) Entgegenhaltungen:
- WO-A-94/23911
- WO-A-20/05093821
- DE-A1-1102004 051 84
- US-B1- 6 203 617

## Beschreibung

Die Erfindung bezieht sich auf eine Transportvorrichtung für scheibenförmige Werkstücke, insbesondere für Halbleiterwafer, gemäss Anspruch 1.

Bei modernen Vakuumprozessanlagen werden kreisrunde, flache Substrate bzw. Werkstücke, die auch als Wafer bezeichnet werden, in solchen vollautomatisierten Vakuumprozesssystemen oberflächenbehandelt, wie beispielsweise beschichtet, geätzt, gereinigt, thermisch behandelt etc. Um derartige Prozesse zu automatisieren und um mehrstufige Prozesse in verschiedenen Anlagenbereichen durchführen zu können, werden hierbei automatisierte Transportsysteme, eine Art Handling-Roboter, eingesetzt. Insbesondere die Behandlung von Halbleiterwafer erfordert bei derartigen Prozessen eine sehr hohe Qualität der Behandlung, wie insbesondere hohe Reinheit, hohe Präzision und sorgfältiges Behandeln der Substrate. Wegen den erwähnt hohen Anforderungen weisen derartige Anlagen bevorzugt eine Schleusenkammer auf, wo die Wafer von atmosphärischer Umgebung in einen Vakuumraum verbracht werden und danach in eine Prozessstation oder in der Regel nacheinander in mehrere Prozessstationen, um die geforderte Oberflächenbearbeitung vornehmen zu können. Die Wafer werden hierbei mit Hilfe einer Transporteinrichtung in einer horizontalen Transportebene von der Schleusenkammer in die Prozesskammer gebracht, wobei nach Ablegen des Wafers in der Prozesskammer diese in der Regel abgeschlossen wird, um dort den Prozess unter den geforderten Vakuum-und Prozessbedingungen durchführen zu können. Auf die selbe Art und Weise wird, wenn mehrere Prozessschritte benötigt werden, der Wafer wieder aus der einen Prozesskammer heraustransportiert und für den nächsten Prozessschritt in eine andere Prozesskammer transportiert. Besonders bevorzugte Anlagentypen sind hierbei sogenannte Clustersysteme. Bei derartigen Systemen wird die Schleusenkammer und die Prozesskammer bzw. mehrere Kammern um die im wesentlichen zentrale Transportkammer peripher angeordnet. Bei mehr als einer Schleusenkammer und insbesondere bei mehreren Prozesskammern werden diese Kammern in einer Art sternförmigen Anordnung um die zentral liegende Transportkammer angeordnet. Die Transporteinrichtung befindet sich dann in dieser zentral liegenden Transportkammer und hat Zugriff einerseits auf die mindestens eine Schleusenkammer und andererseits auf die Prozesskammern. Zwischen der Transportkammer und den übrigen Kammern wird üblicherweise und bevorzugt ein sogenanntes Schleusenventil angeordnet, um die Kammern gegeneinander beim Schleusenvorgang bzw. beim Prozessschritt gegeneinander abschotten zu können. Beim Transportvorgang eines Wafers greift dann die Transporteinrichtung entsprechend durch die offenen Schleusentore hindurch, um den Wafer am gewünschten Ort abzulegen.

Die Transporteinrichtung bewegt den Wafer translatorisch in einer Ebene und somit in zwei Bewegungsrichtungen. Bei den vorerwähnten bevorzugten Clustersystemen mit in der zentralen Transportkammer angeordneten Transporteinrichtung ist diese üblicherweise als Vorrichtung ausgebildet welche um ein Rotationszentrum dreht und damit die eine rotierende Bewegungsrichtung bildet und welche eine weitere zweite translatorische Bewegung radial zu diesem Rotationszentrum von diesem Rotationszentrum weg und hin ausführen kann. Auf dieser Transporteinrichtung, beispielsweise einem in horizontaler Ebene drehbaren, in der Länge verstellbaren Armmechanismus, wird dann der zu transportierende Wafer im Endbereich dieses Armes abgelegt. Eine derartige Anordnung kann dann ohne weiteres auch über grössere Wegdistanzen, beispielsweise in Grössenordnungen von 1 m oder mehr, einen Wafer von einer Schleusenkammer in die Transportkammer und von dort wiederum in die Prozesskammern hinein- und hinaustransportieren und durch die entsprechenden geöffneten Schleusentüren hindurch greifen. Der Wafer wird zu Beginn des Transportzyklus an Atmosphäre auf der Transportvorrichtung so präzise wie möglich und immer in der selben Position abgelegt, um diesen danach auch präzise an eine vorbestimmte Position transportieren zu können. Sowohl das Ablegen des Wafers auf der Transportvorrichtung wie auch die Transportvorrichtung selbst ist aber mit einer bestimmten Ungenauigkeit bzw. mit Toleranzfehlern behaftet. Weitere Ungenauigkeiten bzw. Verschiebungen der Waferposition auf der Transportvorrichtung können auch in der Prozessstation erfolgen durch Einwirkungen in der Prozesskammer.

Ein besonderes Problem bei der Handhabung von scheibenförmigen Werkstücken ergibt sich wenn diese sehr dünn sind im Verhältnis zum Durchmesser und sich diese entsprechend stark durchbiegen. Also insbesondere bei Halbleiterwafern welche etwa einige zehntel Millimeter Dick sind, wie vorzugsweise 0,07 bis 0,3 mm bei einem Durchmesser von 100mm bis 300mm. Die Durchbiegung kann hierbei, je nach Art der Auflage im Bereich von einigen zehntel Millimeter bis einige Millimeter betragen. Die erschwert dann die exakte Handhabung und Positionierung innerhalb einer Transportanordnung erheblich, zumal die Grösse der Verbiegung verschieden ausfallen kann. Besonders problematisch ist hierbei das Handhabung bzw. Umladung von Halbleiterscheiben aus einer Kassette in die gewünschten Positionen, wie Prozessstationen oder Kammern einer Vakuumprozessanlage. Bei derartige Anlagen werden die Halbleiterwafer horizontal in als Kassetten ausgebildeten Magazinen abgelegt und entnommen, um diese auf kompaktem Raum zwischen zu lagern. Hierbei entstehen besondere Schwierigkeiten bei Wafern, die sich stark durchbiegen in Bezug auf Handhabungspräzision und gewünschter Kompaktheit der Anordnung und Sicherheit der Handhabung.

Aus der EP 0 696 242 B2 ist eine Transportvorrichtung für Halbleiterwafer bekannt geworden, welche es ermöglicht kreisrunde Halbleiterscheiben mit Hilfe eines in der Höhe verstellbaren und um seine Achse drehenden Handhabungsroboter mit einem in horizontaler Ebene ausfahrbaren Tragarm bzw. Tragelement scheibenförmige Werkstücke abzuheben oder abzulegen und in eine andere Position zu bringen. Es können damit beispielsweise Werkstücke mit einem Transportarm aus einer Kassette entnommen werden und in eine andere Position transportiert werden, wo sie beispielsweise bearbeitet werden. Bei Vakuumprozessanlagen müssen die Werkstücke ein- und ausgeschleust werden, sei es von Atmosphäre in die Anlage oder innerhalb der Anlage zwischen verschiedenen Kammern. Zu diesem Zweck greift der vorerwähnte Transportarm des Roboters bedarfsweise und gesteuert durch die entsprechenden Schleusentore hindurch zur zielgerechten Transportierung des Werkstückes. Hierbei werden zur Zwischenlagerung der Werkstücke je nach Anlagenkonzept Kassetten verwendet, die auf engem Raum mehrere Werkstücke aufnehmen können und entweder ausserhalb der Anlage und / oder innerhalb der Anlage eingesetzt werden. Die in der Patentschrift vorgestellte Anordnung ermöglicht die Realisierung von Transportvorrichtungen dieser Art. Bei diesen bekannten Transportvorrichtungen wird davon ausgegangen, dass das Werkstück definiert flach bleibt und auch in den Abmessungen definiert ist. Sowohl die Handhabung, wie auch die Substraterfassung mit den entsprechenden elektronischen oder optischen sensoren gehen von diesen Voraussetzungen aus.

Bei grossflächigen, dünnen Werkstücken, die sich stark durchbiegen ergeben sich allerdings mit dieser Vorrichtung erhebliche Probleme und eine Lösung dafür wird nicht angegeben. In diesen Fällen wurden derartige Transportvorrichtungen entsprechend funktionell auch an ihrem Limit betrieben, was die Betriebssicherheit derartiger Anlagen verringert.

Die Patentschrift US 6,203 617 offenbart eine Transportvorrichtung für Glasplatten mit einem horizontal beweglichen, gesteuerten Transportarm an dessen Ende beabstandet zwei längliche Pinzetten zur Aufnahme der Glasplatten angeordnet sind. Weiterhin wird eine Kassette in der Transportvorrichtung offenbart, die an zwei gegenüberliegenden Seiten eine Kammstruktur zur Aufnahme der Glasplatten aufweist, wobei die Pinzetten zwischen die gegenüberliegenden Kammstrukturen auch mit darin abgelegten Glasplatten berührungslos zum Anheben und Ablegen derselben eingeführt werden können. Die Pinzetten sind parallel zur Kammstruktur angeordnet. Die Transportvorrichtung weist eine Sensoreinheit auf mit einem Lichtemitter und einem Lichtempfänger, sowie Spiegel zur Lenkung des Lichtes. Die Sensoreinheit ist am Hauptteil des Transportarmes angeordnet und ermöglicht auf diese Art die Feststellung ob eine Glasplatte vorhanden ist oder nicht.

Die Aufgabe der vorliegenden Erfindung liegt darin, die vorerwähnten Nachteile des Standes der Technik zu beseitigen. Insbesondere besteht die Aufgabe darin, ein Vorrichtung und ein Verfahren zum Transport von dünnen durchbiegsamen scheibenförmigen Werkstücken, insbesondere von Halbleiterscheiben zu realisieren, welche eine hohe Präzision und Zuverlässigkeit ermöglichen, insbesondere möglichst ohne Werkstückdefekten womit eine hohe Wirtschaftlichkeit im Produktionsprozess erreicht werden kann.

Die Aufgabe wird erfindungsgemäss durch eine Transportvorrichtung für Werkstücke, nach Anspruch 1 gelöst und mit einem Verfahren nach Anspruch 12. Die abhängigen Ansprüche definieren weitere vorteilhafte Ausführungsformen.

Die Lösung besteht gemäss Erfindung darin, dass die Durchbiegung des flachen Werkstückes bis zur natürlichen Form zugelassen wird und die Handhabung und die Detektierung des Werkstükkes dieser Deformierung des Werkstückes berücksichtigt wird und bezogen und ausgerichtet wird auf Positionen bzw. Orte die zu Beginn des Transportprozesses klar definiert sind und während dem ganzen Prozess eingehalten werden. Alle Handhabungs-und Detektionselemente sind auf das Werkstück konzentriert unter Berücksichtigung der Toleranzbereiche und deren Grenzen welche durch die beteiligten Vorrichtungen in der Prozessanla-ge mechanisch und elektrisch vorliegen bezogen auf die Ausgangslage des Werkstückes in der Prozessanlage. Die Prozessanlage wird hierbei derart realisiert, dass alle Bereiche, die nicht innerhalb diesen klar definierten Zonen liegen, keinen signifikanten Einfluss auf die Funktion oder die Zuverlässigkeit des Transport- bzw. Handhabungsprozesses haben können.

Die Erfindung umfasst eine Transportvorrichtung für scheibenförmige Werkstücke, insbesondere für Halbleiterwafer, mit einem gesteuert, horizontal beweglichen Transportarm an dessen einen Ende zwei längliche Tragelemente beabstandet angeordnet sind zur im wesentlichen horizontalen Aufnahme des Werkstückes und dass eine Kassette vorgesehen ist, welche an zwei gegenüberliegenden Seiten eine Kammstruktur aufweist zur im wesentlichen horizontalen Aufnahme von mehreren Werkstücken, wobei die Tragelemente und die Kammstruktur derart ausgebildet sind, dass diese zwischen zwei benachbarten, beabstandeten Kämmen der Kammstruktur mit den allenfalls darin abgelegten Werkstükken berührungslos eingeführt werden können zum abheben oder ablegen eines Werkstückes mit Hilfe einer zusätzlichen vertikalen Bewegung relativ bezüglich der Kassette und dem Transportarm, wobei die Tragelemente derart angeordnet sind, dass diese beim Kassetteneingriff im wesentlichen je benachbart parallel zur Kammstruktur entlang eines Kammes positioniert sind und dass in diesem Bereich entlang und zwischen zwei benachbarten Kammebenen einseitig und / oder beidseitig der Kassette ein Abtaststrahl vorgesehen ist zur Erfassung eines Werkstückes und dessen Position und dass der Abtaststrahl relativ gegenüber der Kassette in der Höhe positionierbar ist, wobei der Abtaststrahl gegenüber der horizontalen Werkstückebene um einen kleinen Winkel verkippt geführt ist.

Die Erfindung wird nun nachfolgend beispielsweise und mit schematischen Figuren näher erläutert. Es zeigen:
- Fig. 1: ein scheibenförmiges Werkstück, wie ein Halbleiter- wafer, in der Aufsicht und in verschiedenen Quer- schnitten mit verschiedenen Beispielen von Durchbie- gungen;
- Fig. 2a: ein Werkstück im Bereich der Auflage mit den maximal möglichen Durchbiegungen;
- Fig. 2b: ein Werkstück in Aufsicht mit definierten möglichen Auflagebereichen, den Handhabungszonen;
- Fig. 3a: eine Kassette im Querschnitt mit mehreren darin ab- gelegten, zum Teil gebogenen Werkstücken;
- Fig. 3b: eine Kassette in Aufsicht mit einem Werkstück;
- Fig. 4a: eine Kassette im Querschnitt entsprechend Figur 3a;
- Fig. 4b: ein Detail der Kassette mit Kammstruktur auf einer Seite mit Werkstück im Bereich der Auflage;
- Fig. 4c: ein Werkstück in Aufsicht mit den sich ergebenden zulässigen Handhabungszonen;
- Fig. 5: ein Werkstück in Aufsicht mit Darstellung der Aufla- ge auf den Tragelementen welche innerhalb der zuläs- sigen Handhabungszonen aufliegen;
- Fig. 6a: ein Werkstück im Querschnitt mit Darstellung der Ab- taststrahlen entlang der Kammstruktur;
- Fig. 6b: im Querschnitt, Werkstücke in der Kassette abgelegt mit verschiedenen möglichen Durchbiegungen;
- Fig. 6c: ein Detail gemäss Figur 6b auf einer Seite der Kas- sette im Auflagebereich und im Querschnitt zum Ab- taststrahl;
- Fig. 6d: in Aufsicht ein Werkstück in der Kassette mit Dar- stellung der Abbildungszonen des Abtaststrahles auf dem Werkstück;
- Fig. 7a: im Querschnitt ein gebogenes Werkstück mit Auflage auf Stiften;
- Fig. 7b: in Aufsicht ein Werkstück gemäss Figur 7a mit unter das Werkstück geführten Tragelementen;
- Fig. 8a: im Querschnitt Werkstücke in einer Kassette abgelegt die verworfen gebogen sind;
- Fig. 8b: im Querschnitt ein Detail im Bereich der Kammstruk- tur der Kassette gemäss Figur 8a;
- Fig. 8c: in Aufsicht ein Werkstück mit Verwerfung auf Trage- lemente abgelegt;
- Fig. 8d: im Querschnitt ein Werkstück mit Verwerfung mit ge- formtem Tragelement;
- Fig. 9a: in Aufsicht eine Trägerplatte für Werkstücke mit ra- dial angeordneten Tragelementen;
- Fig. 9b: in Aufsicht eine weitere Trägerplatte für Werkstücke mit zirkular angeordnetem Tragelement;
- Fig.10a: in Aufsicht eine Transporteinrichtung mit zwei Transportroboter;
- Fig.10b: in Aufsicht eine Anordnung zur Ausrichtung von Werk- stücken.

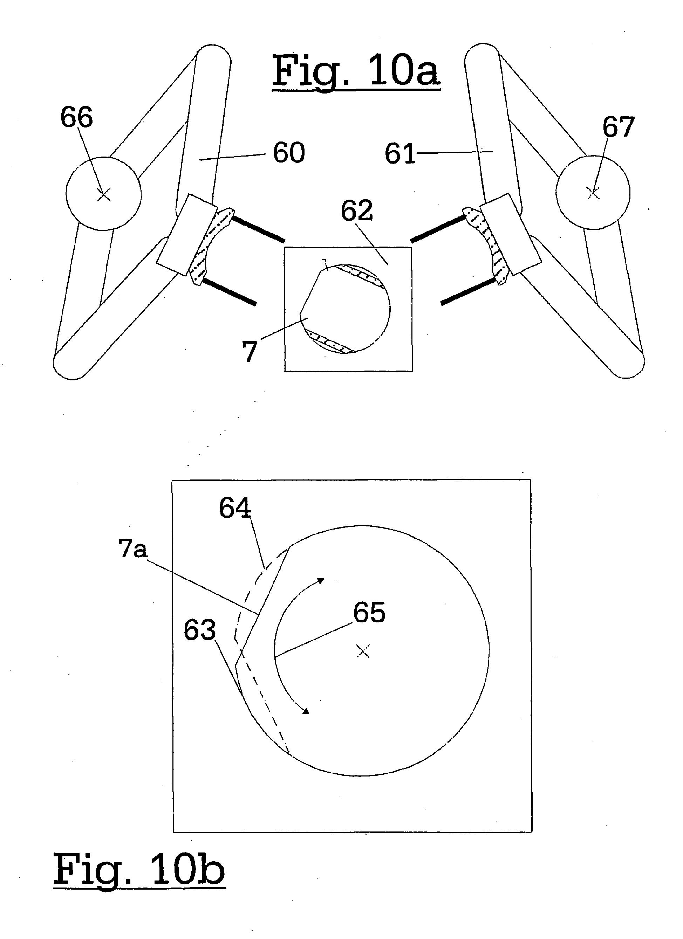

In vollautomatisierten Vakuumprozessanlagen zur Oberflächenbearbeitung von scheinbenförmigen Werkstücken und insbesondere von Halbleiter-Wafern aus Silizium und / oder Germanium müssen diese mit Robotereinrichtungen präzise transportiert werden. Der Transport dieser Werkstücke von einer Position in die andere Position muss präzise reproduzierbar und ohne Beschädigung des Werkstückes erfolgen. Mehrere Werkstücke 7 werden dazu in eine Kassette 20 abgelegt oder aus dieser entnommen, um beispielsweise von Atmosphäre in Vakuum durch eine Schleuse hindurch transportiert zu werden, um danach bearbeitet werden zu können. Nach der Bearbeitung in einer Prozessstation beispielsweise nach Beschichten oder Ätzen des Werkstückes werden diese wieder zurück durch die Schleuse in die Kassette geführt mit Hilfe des Handhabungsroboters. Vakuumprozessanlagen können auch mehrere Prozessstationen aufweisen, die mit einem oder mehreren Handhabungsrobotern bedient werden. In derartigen Prozessanlagen werden die flachen, scheibenförmigen Werkstücke 7 üblicherweise in horizontaler Richtung transportiert. Dazu werden Handhabungsroboter verwendet, die um ihren eigenen Achsen 66, 67 drehen können und die einen Transportarm 61, 60 aufweisen, der in horizontaler Richtung lateral zur Drehachse 66, 67 ausgefahren werden kann, um ein Werkstück 7 in lateraler Richtung zu diesen Achsen transportieren zu können, wie dies in Fig. 10a schematisch dargestellt ist in Aufsicht. Die Aufnahme oder das Ablegen des Werkstückes erfolgt dadurch, dass Tragelemente 26, 27 unter das Werkstück 7 gefahren werden und danach mit einer vertikalen relativen Bewegung von der Kassette 20 oder einer Unterlage 62, 42, 54 durch Relativbewegung abgehoben wird oder abgelegt wird. Die relative Bewegung wird dadurch erzeugt, dass entweder die Kassette oder die Unterlage entsprechend vertikal bewegt wird oder bevorzugt der Handhabungsroboter entsprechend vertikal bewegt wird. Diese Vorgänge müssen sehr präzise ausgeführt werden und es dürfen keine schleifenden bzw. reibenden Bewegungen entstehen an den beteiligten Elementen, welche zu unerwünschtem Abrieb und Partikelbildung führen würden, die die empfindlichen Vakuumprozesse ungünstig beeinflussen würden und zu Ausschuss bei der Produktion führen würde. Zusätzlich erschwert wird die Situation dadurch, wenn dünne grossflächige scheibenförmige Werkstücke 7 bearbeitet werden sollen und transportiert werden müssen, da derartige Werkstücke eine starke Durchbiegung bzw. Verwerfung aufweisen können und dadurch eine zuverlässige Funktion des Transportmechanismus beeinträchtigen können. Um die Wirtschaftlichkeit bei der Halbleiterproduktion weiter zu steigern werden heute vermehrt grössere Durchmesser von Werkstückscheiben verwendet und diese werden zusätzlich immer dünner, wodurch sich das Verbiegungsproblem verstärkt. Es werden heute Scheibendurchmesser von 100mm bis 300mm Durchmesser eingesetzt bei Dicken von 0,07 mm bis etwa 0,6 mm. Daraus ergeben sich je nach Verhältnis Durchbiegungen die im Bereich von einigen Zehntel mm liegen oder gar bis zu mehreren mm gehen können.

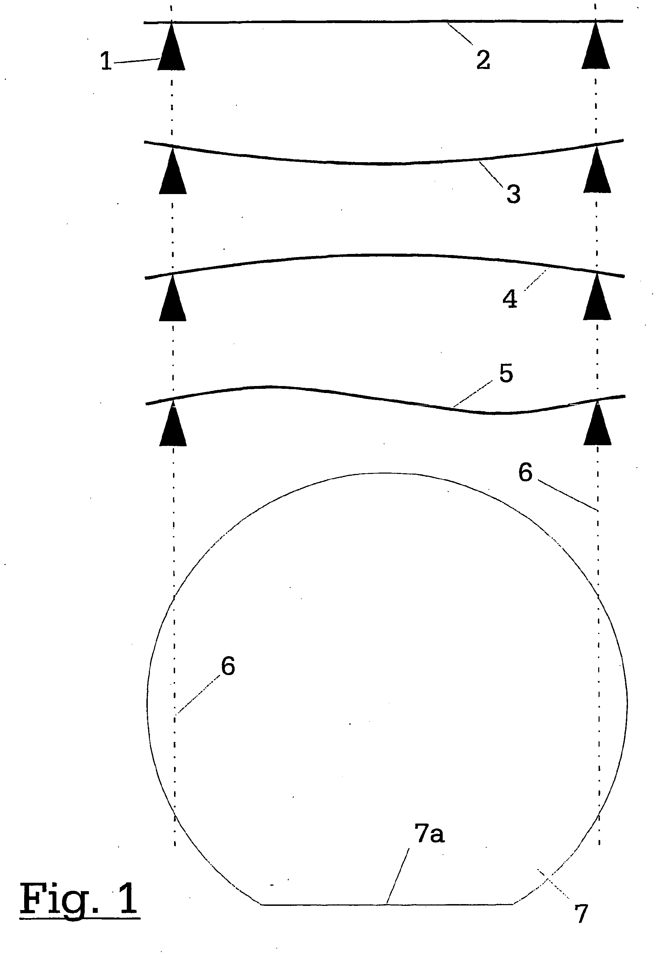

Für die Auflage von Werkstücken 7 werden vorzugsweise zwei linienförmige Auflagen 1, welche die Tragelemente 26, 27 bilden, vorgesehen, wie dies in Fig. 1 schematisch dargestellt ist. Die linienförmigen Auflagen 1 sind im wesentlichen parallel zu einander ausgerichtet und von einander beabstandet derart, dass das scheibenförmige Werkstück 7 im Randbereich beidseitig entlang der Auflagelinie 6 auf den Auflagen 1 abgestützt wird. Diese beiden Auflagen 1 sind vorzugsweise als stabförmige Tragelemente 26, 27 ausgebildet. In Fig. 1 ist als Werkstück ein Halbleiterwafer dargestellt mit verschiedenen Arten von möglichen Durchbiegungen. Ein relativ dicker Wafer 2 weist im wesentlichen keine Durchbiegung auf und liegt flach auf den Auflagen 1 auf. Dünne Wafer können sich durch das Eigengewicht nach unten 3 verbiegen oder durch den inneren Stress nach oben 4. Üblicherweise sind diese Verbiegungen zylinderförmig, können aber auch eine Kombination aus mehreren Zylinderformen bestehen, welche unterschiedlich ausgerichtet sind. Diese Kombination der Verbiegungen führt dann zu einem Verbiegungsprofil 5, welches eine sattelförmige Verwerfung des Wafers aufweist. In Standart-Vakuumprozessanlagen zur Bearbeitung von Halbleiterscheiben werden diese in Kassetten eingeführt, welche mehrere Wafer beinhalten. In derartigen Kassetten 20 liegen die Wafer im Randbereich auf parallel geführten Abstützungen auf, derart dass die Fläche des Werkstückes im wesentlichen frei ist. Hierdurch ist nur diejenige Zone des Wafers, welche nahe im Stützbereich aufliegt, in der vertikalen Position gut definiert, unabhängig davon wie stark die Durchbiegung des Werkstückes ist. Diese Position kann charakterisiert werden durch zwei Auflagelinien 6, welche zwei Sehnen im Peripheriebereich des Wafers 7 bilden. Orte auf der Waferfläche, welche zu weit entfernt sind von diesen Auflagelinien 6, sind in ihrer vertikalen Position nicht bekannt bzw. nicht definiert.

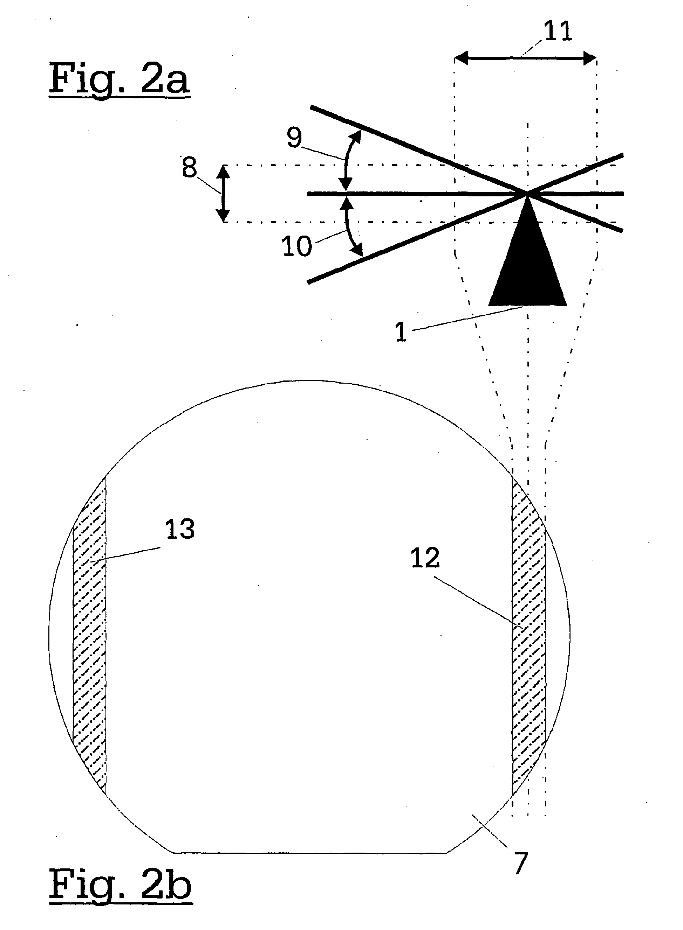

Um einen Bereich um die Auflagelinien 6 zu definieren, welcher für die Handhabung benutzt werden kann, also für das Stützen und Detektieren des Wafers ist der Systemtoleranzbereich 8 in vertikaler Richtung bestimmend, wie dies in Fig. 2a im Querschnitt dargestellt ist. Wenn nun die maximal möglichen Durchbiegungen des Werkstückes nach oben 9 und nach unten 10 berücksichtigt werden, ergibt sich ein von der Horizontalen abweichender Winkel der Werkstückoberfläche, der Aufwärtswinkel 9 und der Abwärtswinkel 10 gegenüber der Auflage 1, woraus sich in der Folge die maximale Handhabungszonenbreite 11 definieren lässt, welche die Handhabungszonen 12, 13 am Werkstück auf beiden Seiten definieren. Somit ergeben sich virtuell zwei beabstandete parallele streifenförmige Handhabungszonen 12, 13, welche im Peripheriebereich des scheibenförmigen Werkstükkes liegen, wie dies in der Aufsicht in Fig. 2b dargestellt ist.

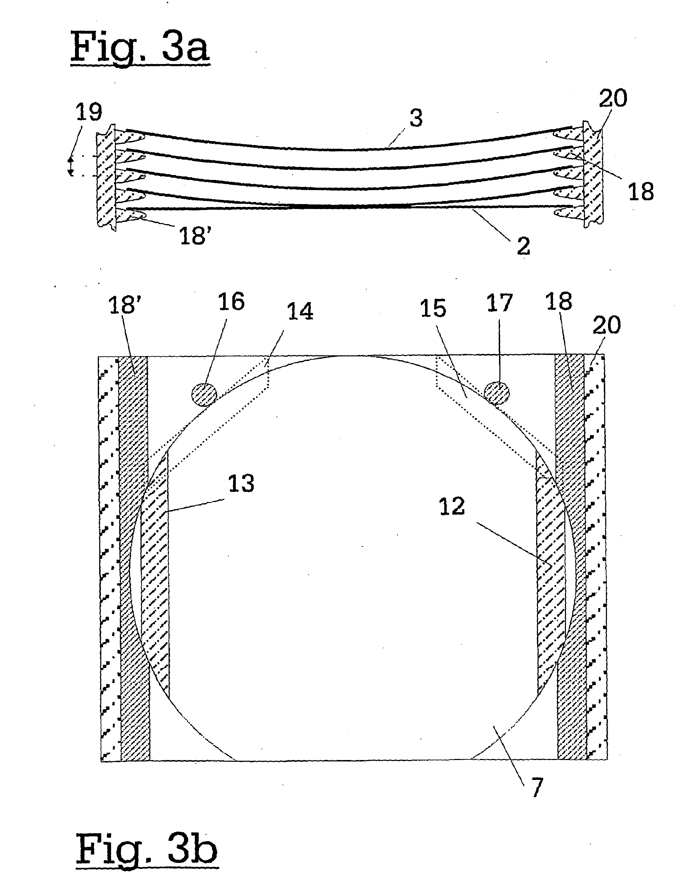

Wenn die Regeln, wie sie zuvor definiert worden sind, auf eine Kassette 20 für dünne Werkstücke 7 angewendet werden, ist ersichtlich, dass die Auflagezonen des Werkstückes 7 sich auf zwei parallele Zonen 12, 13 nahe an der Peripherie des Werkstückes 7 begrenzen, wie dies in Fig. 3a im Querschnitt und in Aufsicht in Fig. 3b dargestellt ist. In üblichen Waferkassetten 20 gemäss dem SEMI Standart werden beidseitig des Werkstückes je ein zusätzliches Endauflagemittel 14, 15 angeordnet, welche in den Innenbereich der Kassette 20 ragen. Derartige nach innen ragende Auflagemittel 14, 15 in Fig. 3b gestrichelt eingezeichnet können bei der vorliegenden Erfindung nicht verwendet werden. Um die horizontale Position des Werkstückes 7 in der Kassette zu begrenzen bzw. zu definieren, müssen Anschlagmittel 16, 17 vorgesehen werden, die nur punktuell den Innenbereich der Kassette zwischen den Auflagen 18, 18' beanspruchen bzw. im Bereich der Auflagen und der Handhabungszonen 12, 13 entlang diesen einen Durchgriff ermöglichen für die Detektionsmittel. Als Anschlagemittel werden deshalb dünne stabförmige Elemente 16, 7 bevorzugt. Die Kassette 20 weist auf beiden Seiten eine kammförmige Struktur 18, 18' auf, welche eine schlitzförmige Anordnung bildet, die im peripheren Bereich die scheibenförmigen Werkstücke 7 aufnehmen und abstützen kann. Die Kassette 20 bildet dadurch eine Anordnung mit mehreren Aufnahmeschlitzen zur Aufnahme von mehreren Werkstücken 7. Hierbei ist es wichtig, dass die Kammstruktur eine Kammdistanz 19 aufweist, die gross genug ist, um zu vermeiden, dass sich benachbart eingeführte Werkstücke 7 auch bei Verbiegungen nicht berühren. Wenn beispielsweise Werkstücke 3 verwendet werden, die sich nach unten biegen und Werkstücke 2, die flach sind, dann muss die Kammdistanz 19 grösser sein als die nach unten gerichtete Durchbiegung 3 des Werkstückes 7. Wenn Werkstücke 7 verwendet werden, die sich sowohl nach oben wie nach unten verbiegen, muss die Kammdistanz 19 grösser sein als die Summe der maximal zu erwartenden Verbiegung nach oben und nach unten.

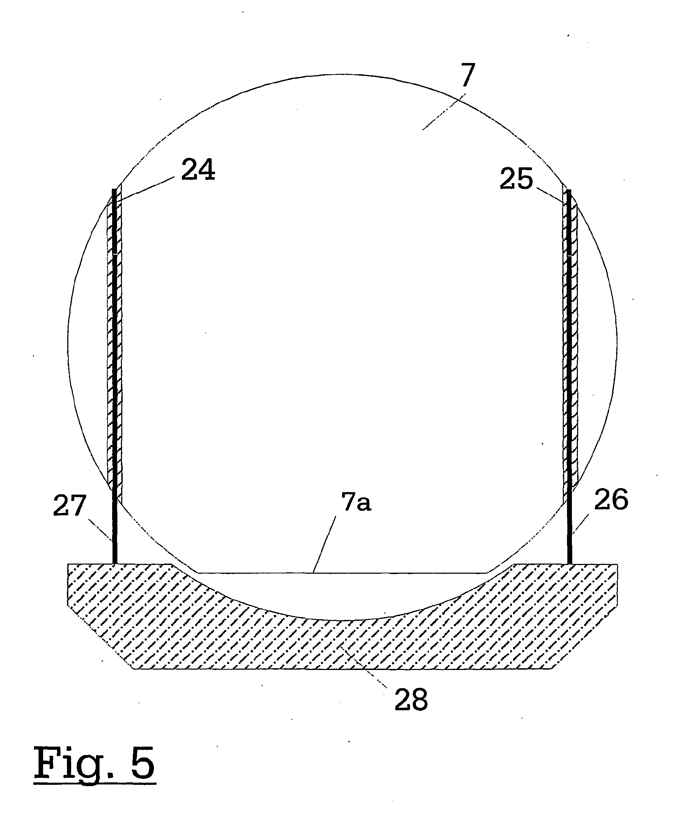

Um das Werkstück 7 abheben und tragen zu können, sind am Ende des Robotertragarmes Tragelemente 21, 22 angeordnet, auf welchem das Werkstück 7 abgelegt wird. Am horizontal beweglichen Tragarm des Roboters ist ein Tragelementträger 28 angebracht und an diesem sind zwei längliche beabstandet parallel angeordnete Tragelemente 26, 27 angeordnet, welche vorzugsweise stabförmig ausgebildet sind, wie dies in Fig. 5 in der Aufsicht dargestellt ist. In Fig. 5 ist gezeigt, wie ein scheibenförmiges Werkstück, ein Halbleiterwafer 7, auf den Tragelementen 26, 27 abgelegt ist. Die Dicke der Tragelemente 26, 27 ist begrenzt, das heisst sie müssen dünn genug sein, so dass diese zwischen zwei benachbarte Werkstücke 7 in der Kassette ohne diese zu berühren für den nachfolgenden Abhebevorgang oder nach dem Ablegen eines Werkstückes 7 in der Kassette. Die Tragelemente 26, 27 sind deshalb vorzugsweise stabförmig ausgebildet und müssen genügend Steifigkeit aufweisen, so das diese sich nicht unerwünscht verbiegen können, was die Handhabungstoleranzen zusätzlich erhöhen würde.

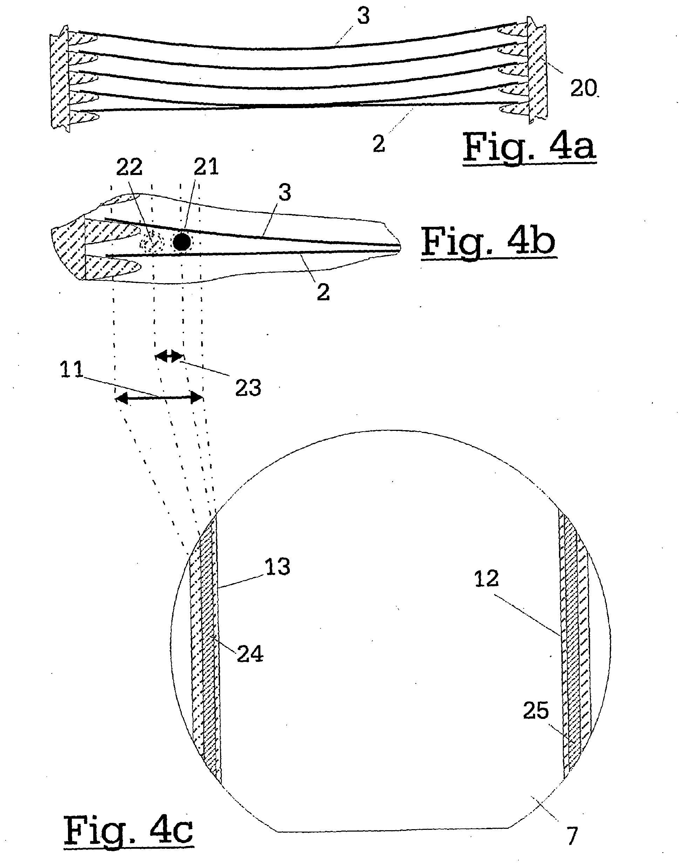

Die Tragelemente 26, 27 liegen direkt an der Unterseite des scheibenförmigen Werkstückes 7 an beim Abheben und Transportieren des Werkstückes 7. Um die Tragelemente 26, 27 wird in der Folge je eine zulässige streifenförmige Handhabungszone 24, 25 definiert, innerhalb derer die Tragelemente 26, 27 bei der Handhabung sich bewegen müssen. Die Dimensionierung der Tragelemente 26, 27 wird bestimmt durch die offenen Abmessungen in der beladenen Kassette 20. In Fig. 4a ist beispielsweise ein Wafer 3 in einer Kassette 20 dargestellt, der nach unten gebogen ist gegenüber einem flachen Wafer 2, die in den Schlitzen der Kassette liegen. Der nach unten gebogene Wafer 3 soll mit den Tragelementen 26, 27 aus dem Kassettenschlitz abgehoben und entfernt werden. Die maximal zulässige Dicke 21 des Tragelementes 26, 27 ist abhängig vom zur Verfügung stehenden Zwischenraum des obenliegenden und untenliegenden Wafers 3, 2 und den Handhabungstoleranzen, welche benötigt werden, um den Wafer in die Kassette oder aus der Kassette zu bewegen, wie dies in Fig. 4b im Detail im kritischen Randbereich im Querschnitt dargestellt ist. Im kammnahen Bereich entspricht der grösstmögliche Abstand zwischen den benachbarten Wafern 2, 3 im wesentlichen der Kammdistanz 19, dessen Lage die äussere Position der zulässigen Handhabungszonenbreite 23 bildet und die innere Grenze der zulässigen Handhabungszonenbreite 23 ist etwas weiter beabstandet von der Kammstruktur 18 gegen innen, welche limitiert wird durch den Durchmesser 21 des Tragelementes 26, 27 und abhängig von den Durchbiegungen der Wafer 2, 3, ohne dass sie sich gegenseitig berühren. Aus diesen beiden möglichen Positionen ergibt sich die zulässige Handhabungszonenbreite 23, welche die zulässige Handhabungszone 24, 25 bestimmen und innerhalb der Handhabungszone 12, 13 liegen muss wie dies in den Fig. 4b und 4c dargestellt ist.

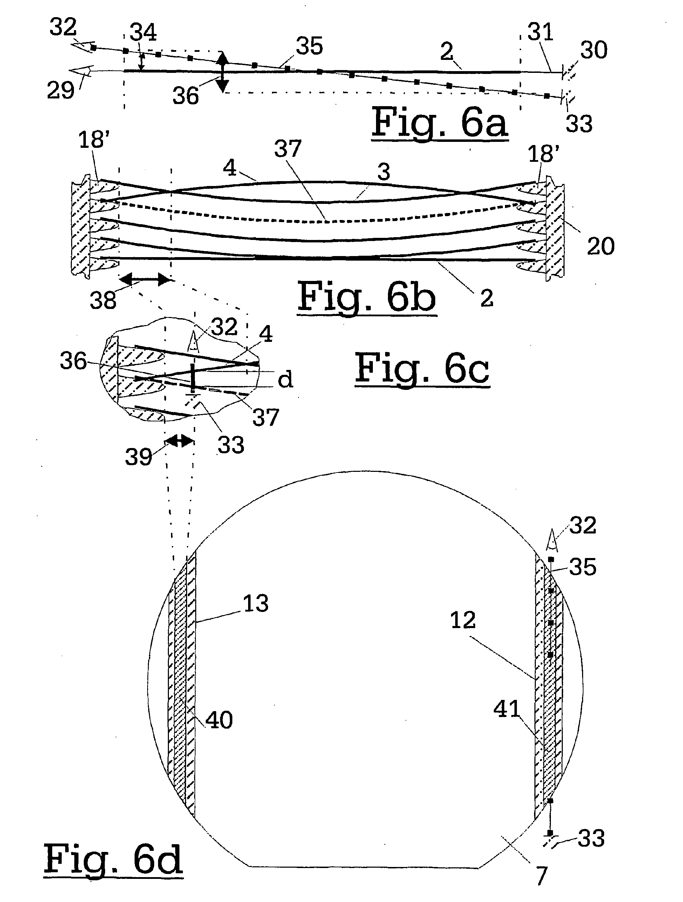

Die Definitionen für die Ausbildung des Kassettenabbildungssystems werden anhand der Fig. 6a bis 6d nachfolgend erklärt. Bei bekannten Abbildungssystemen werden beispielsweise reflektierende Lasersysteme verwendet bei denen der Lesesensor 29 und der Reflektor 30 parallel zur Waferfläche und gegenüberliegend ausserhalb des Wafers angeordnet sind. Der Lesesensor 29 ist auch die Quelle des Laserabtaststrahles 31, der ebenfalls parallel zur Waferoberfläche verläuft und im Reflektor 30 zurückreflektiert wird auf den Lesesensor 29. Diese Strahlanordnung mit Abtaststrahl 31, Lesesensor 29 und Reflektor 30 ist in bekannter Weise nahe im Bereich der Zentrumslinie der Waferebene geführt. Wenn nun ein Wafer in den Bereich des Abtaststrahles 31 bewegt wird, wird dieser unterbrochen und die Position wird detektiert. Diese bekannte Methode wird verwendet bei relativ dicken Werkstücken bzw. Halbleiterwafern, die dicker als 0,6 mm sind. Für dünnere Wafer ergeben sich Probleme, wenn diese Methode zur Detektion verwendet wird. Wenn der Wafer dünner ist als der Durchmesser des Abtaststrahles 31, aber trotzdem noch flach ist, dann wird der Abtaststrahl 31 durch den Wafer 2 nicht unterbrochen. Wenn das Abbildungssystem einen beladenen oder unbeladenen Schlitz der Kassette 20 detektieren soll, kann dies über dies nicht zuverlässig detektiert werden, weil der Zentrumsbereich des Wafer 2 auf welchen detektiert wird, einerseits zu einem nach oben 4 oder nach unten 3 gebogenen Wafer gehören kann, wie dies in den Fig. 6a, 6b und 6c im Querschnitt schematisch dargestellt ist.

Um das erste Problem zu lösen, soll erfindungsgemäss der Lesesensor 32 und der zugehörige Reflektor 33 für dünne Wafer gegenüberliegend ausserhalb der Ebene des Wafer 2, 3, 4 angeordnet werden und zusätzlich soll der Lesesensor 32 und der Reflektor 33 ausserhalb der Waferebene etwas versetzt angeordnet werden, so dass der Abtaststrahl 35 gegenüber der planen Waferebene 2 leicht verkippt geführt wird, woraus ein bevorzugter Kippwinkel 34 resultiert im Bereich von 0,5° bis 2,0° .

Der kleine Kippwinkel 34 des Abtaststrahles 35 erzeugt eine Projektion des Wafer in der Richtung des Abtaststrahles 35 derart, dass eine wesentlich grössere Dicke 36, die sogenannte aufscheinende Dicke 36, erscheint als der vorliegende Wafer tatsächlich aufweist.

Der Abtaststrahl 35 für dünne verbiegbare Wafer 2, 3, 4 mit dem Lesesensor 32 und dem Reflektor 33 werden im Randbereich der Waferperipherie angeordnet, also im Bereich der Kammstruktur 18, 18' der Kassette 20. Bei Blickrichtung in Abtaststrahlrichtung erscheint somit nicht ein punktförmiger Strahl wie dies bei bekannten Systemen üblich ist, sondern eine aufscheinende Dicke 36 des Wafers 2, 3, 4 abhängig von der Grösse des Abtaststrahlkippwinkel 34 wie dies in Fig. 6c im Detail im Querschnitt dargestellt ist. Der Abtaststrahl 34 ist somit in der Lage neben planen Wafern 2 auch entsprechend nach oben oder nach unten durchgebogene Wafer 3, 4 zu erfassen, wodurch auch die zweite Problemstellung gelöst werden kann. Um dieses zweite Problem eindeutig bestimmen zu können, muss beachtet werden, dass nahe im Bereich der Kammstruktur 18, 18' der Kassette 20, wo der Abtaststrahl 35 geführt wird, die vertikale Distanz d zwischen einem nach oben gebogenen Wafer 4 und einem nach unten gebogenen Wafer 37 innerhalb der gleichen Schlitzanordnung geringer ist als die aufscheinende Dicke 36, die der verkippte Abtaststrahl 35 vorgibt. Bei vorliegenden bekannten maximal möglichen Verbiegungsgrad der Wafer 3, 4 nach oben und unten ist es möglich, die maximale Abbildungszonenbreite 38 zu bestimmen. Die eine Grenze ergibt sich durch die Spitzen der Kammstruktur 18, 18' bei welchen sich ein nach oben gebogener Wafer 4 und ein nach unten gebogener Wafer 3 schneiden würden, wenn diese Wafer 3, 4 in einen benachbarten Schlitz der Kammstruktur 18, 18' liegen würden. Es müssen somit zwei Bedingungen eingehalten werden, um dünne verbiegbare Wafer zuverlässig detektieren zu können. Erstens muss, wie erwähnt, die aufscheinende Dicke 36 im Bereich des verkippten Abtaststrahles 35 grösser sein als der maximal mögliche Abstand d im Laserstrahlbereich von einem nach oben gebogenen Wafer 4 und zwischen einem nach unten gebogenen Wafer 3, wenn diese im gleichen Schlitz der Kassette 20 liegen würden. Als zweite Bedingung muss erfüllt sein, dass die nun tatsächliche bestimmte Handhabungszonenbreite 39 für das Messsystem innerhalb der maximalen Abbildungszonenbreite 38 liegt. Aus der so bestimmten Handhabungszonenbreite 39 ergeben sich die beiden Abbildungszonen 40, 41, die beidseits des Wafers liegen nahe der Kammstrukturen 18', 18 der Kassette 20. Innerhalb deren die Abtaststrahl 35 geführt werden kann und mit den ausserhalb des in der Linie liegend angeordneten Lesesensor 32 und Reflektor 33. Auf diese Art kann innerhalb der Abbildungszone 40, 41 jeder deformierte dünne Wafer an beliebigem Ort innerhalb dieser Zonen sicher detektiert werden.

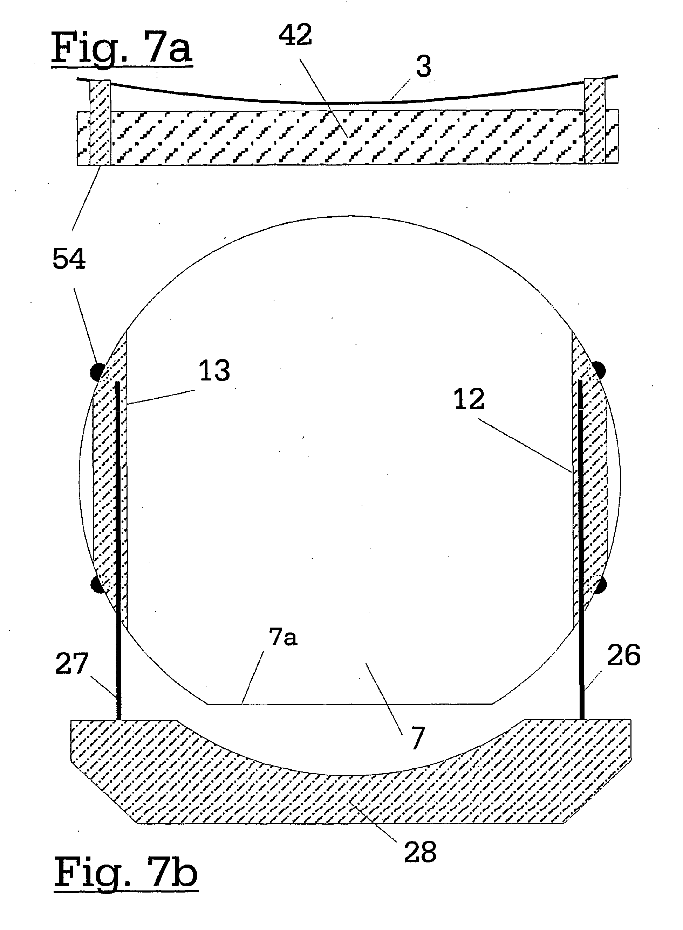

Üblicherweise wird die Handhabung des Wafer derart vorgenommen, dass dieser auf eine flache Oberfläche 42 positioniert und abgelegt wird, bevor er in der Prozessstation bearbeitet wird, wie die in Fig. 7a im Querschnitt dargestellt ist. Um das System zu befähigen, den Wafer auf der Oberfläche korrekt ablegen zu können, wird die ursprüngliche Auflageposition wie in der Kassette mit Auflagen erzeugt, welche auf die Handhabungszonen 12, 13 am Wafer bezogen sind. Es werden zur Erzeugung oder Einhaltung beispielsweise Waferauflagestifte 54, welche auch Pin genannt werden, verwendet, auf welchen der Wafer 3 liegt und welche dafür sorgen, dass der Abstand zwischen Unterlage 42 und dem Wafer 3 gross genug ist, um zu ermöglichen, dass Tragelemente 26, 27 dazwischen eingeführt werden können, wie dies in den Fig. 7a und 7b dargestellt ist. Die Waferauflagestifte 54 werden für diesen Vorgang vorzugsweise hochgefahren, wodurch der Wafer 3 sich von der Unterlage 42 abhebt und, wenn er entsprechend dünn ist, sich auch durchbiegt. Um das Abheben des Wafer 3 zu erreichen, kann auch die Waferunterlage 42 in vertikaler Richtung bewegt werden und es können auch andere Halteelemente zur Erzeugung der Distanz zwischen Wafer und Unterlage 42 verwendet werden als sogenannte Waferauflagestifte 54. Zum Abheben oder Ablegen des Wafers 3 auf die Unterlage liegt dieser im eingefahrenen Zustand der Tragarme 26, 27 ausschliesslich im Bereich der definierten Handhabungszonen 12, 13 auf für den Transportvorgang, wobei diese am Tragelementträger 28 gehalten werden, welcher am Roboterarm fixiert ist, wie dies in Aufsicht anhand von Fig. 7b anhand eines Beispiels für einen Halbleiterwafer 7 dargestellt ist.

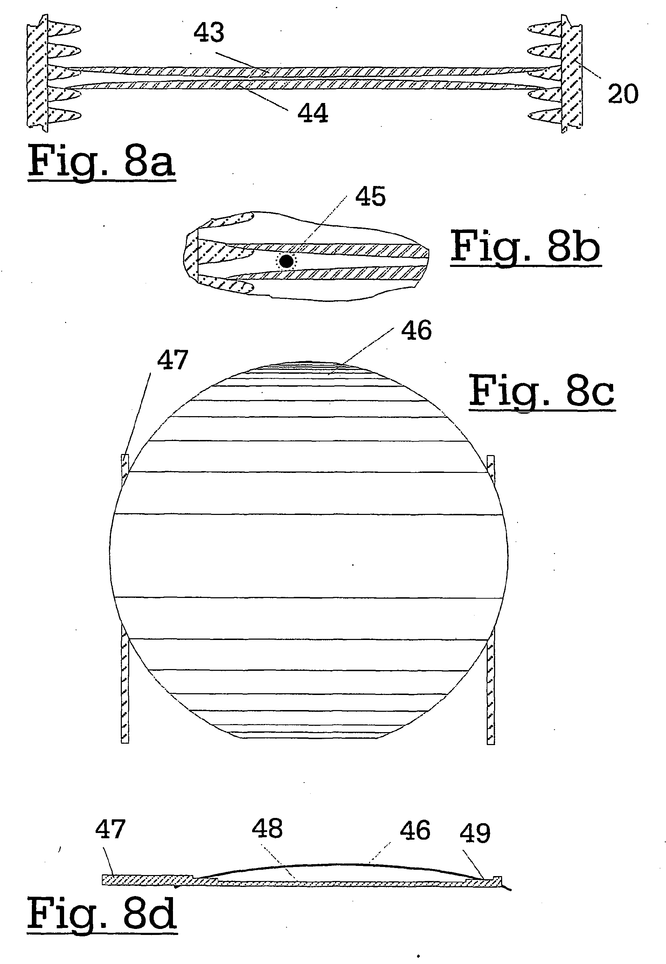

Nicht alle Wafer sind entlang einer Zylinderachse gebogen parallel zu den Handhabungszonen, welche durch das System definiert sind. Wafer in einer Kassette können auch im ungünstigen Fall derart gebogen sein, dass sie parallel zu einem Zylinder senkrecht zur Auflagelinie gebogen sind. Wenn derartige Wafer nach unten 44 oder nach oben 43 gebogen sind und in einer Kassette 20 platziert sind, dann ist die tatsächliche Projektion und Definition der Form nicht sehr unterschiedlich von derjenigen wie sie zuvor beschrieben worden sind. Die Bestimmung des Querschnitts 45 des Tragelementes 26, 27 und auch die anderen Grössen erscheinen identisch und führen nicht zu einer unterschiedlichen Konfigurierung des Systems. Zusätzlich können Tragelemente 26, 27 wie am Beispiel des Tragelementes 47 in Querschnitt in Fig. 8d dargestellt auch geformt ausgebildet werden, um sich am gebogenen Wafer 46 anzupassen. In vorliegendem Beispiel wird das Tragelement 47 mit je einer Stufe 48 versehen im peripheren Bereich des Wafers 46 derart, dass der Wafer 46 sich im mittleren Bereich nach unten durchbiegen kann und dadurch in eine vorgegebene gewünschte Form vorzugsweise in eine ebene Fläche anpassen kann, um im wesentlichen die vorerwähnten Betrachtungen direkt übernehmen zu können. Im Randbereich können vorzugsweise weitere Stufen vorgesehen werden um den Wafer dort fixieren zu können auf dem Tragelement 47, um während dem Transport zu vermeiden, dass der Wafer sich verschiebt bei der Transportbewegung. Es ist auch von Vorteil das Tragelement 47 aus einem Material zu fertigen oder mit einem entsprechenden Material zu beschichten, dass eine grössere Oberflächenreibung entsteht, um den vorerwähnten Effekt zu verringern.

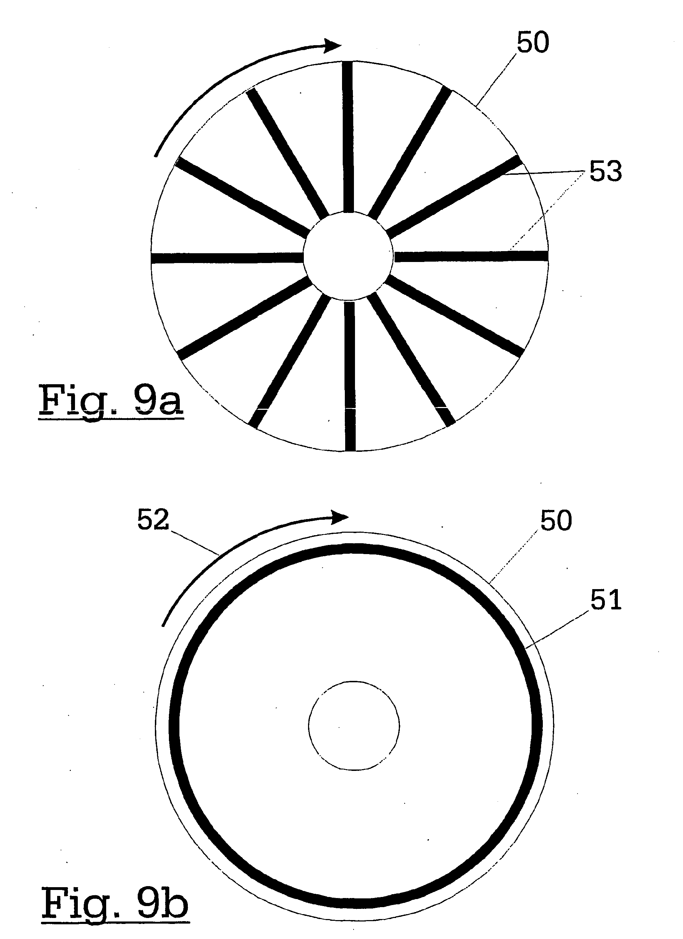

In einer Waferprozessanlage ist der einzige Ort, wo die Wafertraglinienmethode nicht benutzt wird, die Waferrotationsausrichtungsstation, wo Wafer in ihrer ebenen Orientierung gegenüber einer Werkstückmarkierung 7a ausgerichtet werden. Ein Wafer, der diese Station erreicht, ist üblicherweise per Definition nicht auf die entsprechende Markierung 7a ausgerichtet. Dies bedeutet, dass die Auflageachsen zufällig orientiert sind gegenüber der Wafermarkierung 7a. Der Zweck dieser Station ist den Wafer in eine klar definierte Rotationsposition zu bringen, um ihn weiter zu bearbeiten. Dies bedeutet, dass der Wafer rotiert werden muss. Diese Rotationsbewegung führt auch zu einer Rotation der Auflagelinien um das Zentrum des Wafer, das heisst die Auflagelinien vor und nach dem Ausrichten sind unterschiedlich. Um dies zu berücksichtigen, ist es wesentlich, dass die Waferbereiche, welche gehandhabt werden müssen, genau definiert sind in der Höhe und in jeder Rotationsposition des Wafers. Um dies zu erreichen, wird mit Vorteil eine kreisrunde Unterstützung für den Wafer realisiert, welche so nahe wie möglich bei den Auflagelinien bzw. Abbildungszonen 40, 41 liegen. Wie in der Fig. 9b dargestellt wird hierzu eine Auflageplatte 50 verwendet, welche ein kreisrundes Auflagemittel 51 aufweist mit einem Durchmesser, welcher sehr nahe an den Durchmesser der Lage der Abbildungszonen 40, 41 heran kommt. Wenn die Auflageanordnung, welche den Wafer trägt, rotiert wird für die Ausrichtung 52, dann ist das Handhabungssystem immer noch in der Lage, den Wafer nach der Ausrichtung abzuheben. Eine einzelne kreisrunde Unterlagenanordnung 51 ist besonders gut geeignet, wenn zylindrische Deformationen des Wafers auftreten. Ähnliche Ergebnisse können erreicht werden, wenn der Wafer getragen wird durch eine radial angeordnete Unterlagenanordnung 53 auf der Trägerplatte 50 zur Stützung des Wafers wie dies in Fig. 9a dargestellt ist. Diese Konfiguration kann mit Vorteil verwendet werden, wenn das Werkstück insgesamt nicht zylindrisch gebogen ist.

In einigen Vakuumprozessanlagen zur Bearbeitung von Halbleiterwafern werden zwei oder mehrere Robotersysteme benutzt, um die Werkstücke zu handhaben und zu transportieren. Eine wichtige Konfiguration ist beispielsweise dass ein erster Roboter 60 an einer Anlage an Atmosphäre positioniert ist am sogenannten Front-End, wie das in der Halbleiterindustrie bezeichnet wird, wodurch Wafer in Kassetten hinein und hinaus transportiert werden. Der zweite Roboter 61 kann dann in der Vakuumprozessanlage also in Vakuumumgebung positioniert sein, um Wafer in die Prozessstation und aus der Prozessstation zu transportieren. Um Wafer von Atmosphäre durch eine Schleuse ins Vakuum und zurück zu transportieren und dann Wafer vom Roboter 60 zum Roboter 61, der sich innerhalb der Vakuumkammer befindet, zu transportieren, wird zwischen den zwei Robotern 60, 61 eine Substratübergabestation 62 platziert. Wenn diese Substratübergabestation nicht auf der Verbindungslinie zwischen den zwei Roboterdrehzentern 66, 67 angeordnet ist, dann haben die Wafer 7, welche vom ersten Robotersystem auf die Position 63 platziert sind, nicht die richtige Winkelorientierung gegenüber dem zweiten Robotersystem, bei welchem die Position 64 nötig wäre wie dies in den Fig. 10a und 10b dargestellt ist. In diesem Fall muss die Substratübergabestation 62 mit Mitteln 65 versehen werden, welche es ermöglichen, den Wafer zu rotieren, um die Winkeldifferenz zwischen den zwei benötigten Waferpositionen 63, 64.

## Patentansprüche

1. Transportvorrichtung für scheibenförmige Werkstücke (2, 3, 4, 5, 7,), insbesondere für Halbleiterwafer, mit einem gesteuert, horizontal beweglichen Transportarm an dessen einen Ende zwei beabstandet, längliche Tragelemente (26, 27) angeordnet sind zur im wesentlichen horizontalen Aufnahme des Werkstückes und dass eine Kassette (20) vorgesehen ist, welche an zwei gegenüberliegenden Seiten eine Kammstruktur (18) aufweist zur im wesentlichen horizontalen Aufnahme von mehreren Werkstücken (7), wobei die Tragelemente (26, 27) und die Kammstruktur (18) derart ausgebildet sind, dass diese zwischen zwei benachbarten, beabstandeten Kämmen (19) der Kammstruktur (18) mit den allenfalls darin abgelegten Werkstücken berührungslos eingeführt werden können zum abheben oder ablegen eines Werkstückes (7) mit Hilfe einer zusätzlichen vertikalen Bewegung relativ bezüglich der Kassette (20) und dem Transportarm, **dadurch gekennzeichnet, dass** die Tragelemente (26, 27) derart angeordnet sind, dass diese beim Kassetteneingriff im wesentlichen je benachbart parallel zur Kammstruktur entlang eines Kammes positioniert sind (18) und dass in diesem Bereich entlang und zwischen zwei benachbarten Kammebenen einseitig der Kassette (20) ein Abtaststrahl (35) vorgesehen ist zur Erfassung eines Werkstückes (7) und dessen Position und dass der Abtaststrahl (35) relativ gegenüber der Kassette (20) in der Höhe positionierbar ist, wobei der Abtaststrahl (35) gegenüber der horizontalen Werkstückebene um einen kleinen Winkel (34) verkippt geführt ist.

2. Transportvorrichtung nach Anspruch 1, **dadurch gekennzeichnet, dass** für die Transportvorrichtung mit Transportarm und Kassette (20) Handhabungszonen (12, 13) definiert sind innerhalb derer die Tragelemente (26, 27) mit der Oberfläche des Werkstück (7) interagieren, wobei diese bezüglich des Werkstückes als zwei beabstandet parallel gegenüber liegende streifenförmige Flächen bestimmt sind welche im wesentlichen parallel zu der Kammstruktur (18) ausgerichtet sind bei in die Kassette (20) eingeführtem Werkstück.

3. Transportvorrichtung nach Anspruch 2, **dadurch gekennzeichnet, dass** die Breite (11) der Handhabungszonen (12, 13) bestimmt ist durch die Summe der vertikalen Systemtoleranzen (8) der Transportvorrichtung in Kombination der maximalen Verbiegungen nach oben und unten, die das Werkstück bei Aufliegen auf einer linienförmigen Auflage (1) erreicht mit dessen Verbiegungswinkeln (9, 10) und wo sich diese Winkel mit den horizontalen Ebenen der maximalen vertikalen Systemtoleranzen schneiden.

4. Transportvorrichtung nach Anspruch 2 oder 3, **dadurch gekennzeichnet, dass** das Werkstück (7) ein Halbleiterwafer ist und die Breite der Handhabungszonen 10 bis 20 mm beträgt.

5. Transportvorrichtung nach einem der vorhergehenden Ansprüche, **dadurch gekennzeichnet, dass** der Kippwinkel (34) des Abtaststrahles (35) derart definiert ist, dass der Strahl entlang von zwei benachbarten parallelen Kämmen (18) geführt die Kammdistanz (19) nicht überschritten wird.

6. Transportvorrichtung nach einem der vorhergehenden Ansprüche, **dadurch gekennzeichnet, dass** für die Positionierung eines Werkstückes (7) gegenüber der Kassette (20) eine Vorrichtung zur vertikalen Bewegung der Kassette (20) vorgesehen ist.

7. Transportvorrichtung nach einem der vorhergehenden Ansprüche, **dadurch gekennzeichnet, dass** an dem einen Ende der horizontal angeordneten Kammstruktur (18) mindestens ein Anschlagmittel (16, 17) vorgesehen ist zur Begrenzung der Endposition des Werkstückes in der Kassette (20), wobei dieses Anschlagmittel ausserhalb des Strahlenganges des Abtaststrahles (35) angeordnet sind.

8. Transportvorrichtung nach einem der vorhergehenden Ansprüche, **dadurch gekennzeichnet, dass** die Tragelemente (26, 27) stabförmig ausgebildet sind.

9. Transportvorrichtung nach einem der vorhergehenden Ansprüche, **dadurch gekennzeichnet, dass** eine zweite zulässige Handhabungszonenbreite (24, 25) bestimmt ist welche kleiner ist als die Breite der ersten Handhabungszone (12, 13) und welche innerhalb dieser ersten Handhabungszone liegt welche durch die Systemtoleranzen bestimmt ist und dass diese zweite Handhabungszonenbreite (24, 25) bestimmt ist durch die Querschnitsdimension (21) der Tragelemente (26, 27) und der noch freien Kassettenspaltbreite (23)bei maximal möglichen sich ergebenden Durchbiegungen des Werkstükkes (7).

10. Transportvorrichtung nach einem der vorhergehenden Ansprüche, **dadurch gekennzeichnet, dass** ein weiterer verkippter Abtaststrahl (35') vorgesehen ist auf der gegenüberliegenden Seite des ersten Abtastrahles (35) im Bereich der gegenüberliegenden anderen Kammstruktur (18) der Kassette (20).

11. Transportvorrichtung nach einem der vorhergehenden Ansprüche, **dadurch gekennzeichnet, dass** diese mindestens zwei um die Achsen (66, 67) drehbare Transportrobotter mit je einem Transportarm(60, 61) umfasst und eine Drehvorrichtung (62) zur Ausrichtung (65) der Handhabungszonen (12, 13) mit Bezug auf die Transportrichtung der Transportarme (60, 61) wenn die Übergabeposition des Werkstuckes nicht auf der Linie liegt die die beiden Achsen (66, 67) der Transportroboter verbindet.

## Claims

1. Transport device for disc-like workpieces (2, 3, 4, 5, 7), in particular for semi-conductor wafers, having
a controlled, horizontally mobile transport arm at one end of which are arranged two spaced longitudinal carrier elements (26, 27) for holding the workpieces substantially horizontally, and
a cassette (20) which on two opposing sides has a comb structure (18) for substantially horizontal holding of several workpieces (7), wherein the carrier elements (26, 27) and the comb structure (18) are formed such that said elements can be introduced freely between pairs of adjacent spaced comb teeth (19) of the comb structure (18) for depositing the workpieces thereon,the raising or depositing of a workpiece (7) being by means of an additional vertical relative movement between the cassette (20) and the transport arm, **characterised in that** the carrier elements (26, 27) are arranged such that on cassette engagement these are positioned substantially adjacent parallel to the comb structure along a comb (18), and
in a zone along and between two adjacent comb planes on the one side of cassette (20), a scanning beam (35) is provided to detect a workpiece (7) and its position, and such scanning beam (35) can be positioned in height relative to the cassette (20), the scanning beam (35) being guided tilted through a small tilt angle (34) in relation to the horizontal workpiece plane.

2. Transport device according to claim 1, **characterised in that** for the transport device with transport arm and cassette (20), handling zones (12, 13) are defined within which the carrier elements (26, 27) interact with the surface of the workpiece (7), wherein in relation to the workpiece these are determined as two spaced, strip-like, parallel, opposite surfaces which are aligned substantially parallel to the comb structure (18) when the workpiece is introduced into the cassette (20).

3. Transport device according to claim 2, **characterised in that** the width (11) of the handling zones (12, 13) is determined by the sum of the vertical system tolerances (8) of the transport device in combination with the maximum up and down deflections which the workpiece performs with its deflection angles (9, 10) when lying on a linear support (1), and where these angles intersect with the horizontal plane of the maximum vertical system tolerances.

4. Transport device according to claim 2 or 3, **characterised in that** the workpiece (7) is a semi-conductor wafer and the width of the handling zones is 10 to 20 mm.

5. Transport device according to any of the preceding claims, **characterised in that** the tilt angle (34) of the scanning beam (35) is defined such that with the beam guided along two adjacent parallel combs (18), the comb distance (19) is not exceeded.

6. Transport device according to any of the preceding claims, **characterised in that** for positioning of a workpiece (7) in relation to the cassette (20), a device is provided for vertical movement of the cassette (20).

7. Transport device according to any of the preceding claims, **characterised in that** at one end of the horizontally arranged comb structure (18) is provided at least one stop means (16, 17) to limit the end position of the workpiece in the cassette (20), this stop means being arranged outside the beam path of the scanning beam (35).

8. Transport device according to any of the preceding claims, **characterised in that** the carrier elements (26, 27) are rod-like in formation.

9. Transport device according to any of the preceding claims, **characterised in that** a second permitted handling zone width (24, 25) is determined which is smaller than the width of the first handling zone (12, 13) and which lies within this first handling zone that is determined by the system tolerances, wherein the second handling zone width (24, 25) is determined by the cross section dimension (21) of the carrier elements (26, 27) and the free cassette gap width (23) at the maximum resulting flexions of the workpiece (7).

10. Transport device according to any of the preceding claims, **characterised in that** a further tilted scanning beam (35') is provided on the opposite side of the first scanning beam (35) in the area of the other opposing comb structure (18) of the cassette (20).

11. Transport device according to any of the preceding claims, **characterised in that** it comprises at least two transport robots rotatable about an axis (66, 67) and each having one transport arm (60, 61), and a rotation device (62) for alignment (65) of the handling zones (12, 13) in relation to the transport direction of the transport arms (60, 61) when the handover position of the workpiece does not lie on the line connecting the two axes (66, 67) of the transport robots.

## Revendications

1. Dispositif de transport pour pièces en forme de disques (2, 3, 4, 5, 7), en particulier pour des wafers de semi-conducteurs, comprenant un bras de transport à mobilité horizontale commandée dont l'une des extrémités est équipée de deux éléments porteurs (26, 27) de forme allongée, espacés l'un de l'autre et destinés à recevoir la pièce essentiellement disposée à l'horizontale, ledit dispositif de transport comprenant, en outre, une cassette (20) présentant sur deux côtés en regard une structure en peigne (18) destinée à recevoir plusieurs pièces (7) essentiellement disposées à l'horizontale, les éléments porteurs (26, 27) et la structure en peigne (18) étant conformés de telle sorte qu'il est possible, sans toucher, d'introduire les éléments porteurs entre deux séries de dents (19) - contiguës mais espacées entre elles - de la structure (18) comportant les pièces éventuellement déposées dans celle-ci, afin de retirer ou déposer une pièce (7) à l'aide d'un déplacement supplémentaire vertical par rapport à la cassette (20) et au bras de transport, **caractérisé en ce que** les éléments porteurs (26, 27) sont agencés de telle sorte que, au moment d'entrer dans la cassette (20), ils sont positionnés, pour l'essentiel, chacun en parallèle et adjacent à la structure en peigne (18), le long d'une série de dents, **en ce qu'**il est prévu, dans ce secteur, le long et entre deux plans adjacents de la structure en peigne, sur un côté de la cassette (20), un faisceau explorateur (35) destiné à détecter une pièce (7) ainsi que la position de celle-ci, et **en ce que** le faisceau explorateur (35) peut être placé en hauteur par rapport à la cassette (20), ledit faisceau (35) étant alors dirigé avec un léger angle d'inclinaison (34) à l'égard du plan horizontal de la pièce (7).

2. Dispositif de transport selon la revendication 1, **caractérisé en ce qu'**il est défini, pour ledit dispositif doté d'un bras de transport et d'une cassette (20), des zones de manipulation (12, 13) à l'intérieur desquelles les éléments porteurs (26, 27) peuvent être en contact avec la surface de la pièce (7), lesdites zones (12, 13) étant définies, à l'égard de cette pièce (7), comme deux bandes parallèles espacées en vis-à-vis et orientées, pour l'essentiel, parallèlement à la structure en peigne (18), la pièce (7) étant en place dans la cassette (20).

3. Dispositif de transport selon la revendication 2, **caractérisé en ce que** la largeur (11) des zones de manipulation (12, 13) est définie par la somme des tolérances verticales (8) du système de transport associée aux valeurs maximales de gauchissement vers le haut et vers le bas que la pièce atteint en étant posée sur un support (1) linéaire, aux angles de déformation (9, 10) de la pièce qui en résultent et aux points où ces angles croisent les plans horizontaux des tolérances verticales maximales du système.

4. Dispositif de transport selon la revendication 2 ou 3, **caractérisé en ce que** la pièce (7) est un wafer de semiconducteur et que la largeur des zones de manipulation est comprise entre 10 et 20 mm.

5. Dispositif de transport selon l'une quelconque des revendications précédentes, **caractérisé en ce que** l'angle d'inclinaison (34) du faisceau explorateur (35) est défini de telle sorte que le faisceau guidé le long de deux structures dentées (18) parallèles et adjacentes ne dépasse pas la distance (19) entre les dents.

6. Dispositif de transport selon l'une quelconque des revendications précédentes, **caractérisé en ce qu'**il est prévu, pour le positionnement d'une pièce (7) par rapport à la cassette (20), un dispositif de déplacement vertical de la cassette (20).

7. Dispositif de transport selon l'une quelconque des revendications précédentes, **caractérisé en ce qu'**il est prévu, à l'une des extrémités de la structure en peigne (18) agencée horizontalement, au moins une butée (16, 17) marquant la position finale de la pièce dans la cassette (20), ladite butée étant disposée en-dehors de la trajectoire du faisceau explorateur (35).

8. Dispositif de transport selon l'une quelconque des revendications précédentes, **caractérisé en ce que** les éléments porteurs (26, 27) sont en forme de tige.

9. Dispositif de transport selon l'une quelconque des revendications précédentes, **caractérisé en ce qu'**il est défini une seconde largeur de zone de manipulation (24, 25) plus petite que la largeur de la première zone de manipulation (12, 13) définie par les tolérances de système, la seconde zone étant située à l'intérieur de la première, et **en ce que** la seconde largeur de zone de manipulation (24, 25) est définie par la dimension de la section transversale (21) des éléments porteurs (26, 27) et de la largeur (23) restant libre dans l'interstice de la cassette dans les cas de gauchissement maximal des pièces (7).

10. Dispositif de transport selon l'une quelconque des revendications précédentes, **caractérisé en ce qu'**il est prévu un faisceau explorateur incliné supplémentaire (35') du côté opposé au premier (35), au niveau de la seconde structure en peigne (18) de la cassette (20) faisant face à la première.

11. Dispositif de transport selon l'une quelconque des revendications précédentes, **caractérisé en ce que** ledit dispositif comprend au moins deux robots de transport rotatifs autour des axes (66, 67) et dotés chacun d'un bras de transport (60, 61), ainsi qu'un dispositif de rotation (62) pour aligner (65) les zones de manipulation (12, 13) avec la direction de transport des bras de transport (60, 61) lorsque le point de dépôt de la pièce n'est pas situé sur la droite reliant les deux axes (66, 67) du robot de transport.
